(19) Europäisches Patentamt
European Patent Office
Office européen des brevets

(11) Veröffentlichungsnummer: **0 006 173**
**B1**

(12)

# EUROPÄISCHE PATENTSCHRIFT

(21) Anmeldenummer: **79101758.5**

(22) Anmeldetag: **05.06.79**

(51) Int. Cl.³: **C 07 C 69/003,**
C 07 C 69/52, C 07 C 69/66,
C 07 C 93/20, C 07 C 125/06,
C 07 C 149/14, C 07 F 9/09,
C 08 F 2/50, G 03 C 1/68

(54) **Arylglyoxyloyloxyalkylacrylate, ihre Herstellung und Verwendung in photopolymerisierbaren Bindemitteln**

(30) Priorität: **14.06.78 DE 2825955**

(43) Veröffentlichungstag der Anmeldung:
**09.01.80 Patentblatt 80/01**

(45) Bekanntmachung des Hinweises auf die Patenterteilung:
**12.11.80 Patentblatt 80/23**

(84) Benannte Vertragsstaaten:
**CH DE FR GB IT NL SE**

(56) Entgegenhaltungen:
**US - A - 3 930 868**
**US - A - 4 077 806**

(73) Patentinhaber: **BAYER AG**
**ZENTRALBEREICH PATENTE,**
**MARKEN UND LIZENZEN**
**D - 5090 LEVERKUSEN 1,**
**BAYERWERK (DE)**

(72) Erfinder: **Schuster, Karl-Ernst, Dr.**
**Heideweg 2**
**D - 4173 Kerken 3 (DE)**
**Rudolph, Hans, Dr.**
**Haydnstrasse 9**
**D - 4150 Krefeld 1 (DE)**
**Mayer, Wolfram, Dr.**
**Mozartstrasse 10**
**D - 4150 Krefeld 1 (DE)**
**Rosenkranz, Hans Jürgen, Dr.**
**Heinrich-Kauert-Weg 9**
**D - 4150 Krefeld (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

EP 0 006 173 B1

# Arylglyoxyloyloxyalkylacrylate, irhre Herstellung und Verwendung in photopolymerisierbaren Bindemitteln

Die Erfindung betrifft neue Arylglyoxyloyloxyalkylacrylate und ihre Verwendung zur Herstellung hochreaktiver photopolymerisierbarer Bindemittel. Derartige Bindemittel enthalten auf diese Art und Weise einen eingebauten, nicht vergilbenden dunkellager-stabilen Photoinitiator, der keinen zusätzlichen Beschleuniger behötigt.

UV-Licht-härtende Bindemittel auf Basis von Polyacrylsäureestern werden im allgemeinen mit speziellen Initiatoren wie Benzoinäther, Benzilketal, Benzophenon/tert.-Amin etc. in Mengen bis zu 20 Gew.-%,vorzugsweise 1—5 Gew.-%, bezogen auf härtbare Bindemittel versehen, um eine radikalische Polymerisation zu gewährleisten. Solche Bindemittel und die darin verwendeten Initiatoren gehören zum Stand der Technik und wurden schon häufig beschrieben, z.B. in den Deutschen Offenlegungsschriften DE-OS 2 429 527, 2 244 171 oder 2 349 979.

Leider ist es jedoch so, daß der größte Teil (ca. 90 Gew.-%) des eingesetzten Photoinitiators bei der Härtung durch UV-Licht nicht zur Reaktion gelangt und aus dem vernetzten Film unverändert extrahiert werden kann, wie Untersuchungen von J.I. Geary (Journal of Coatings Technology (49) 626, S. 25, 1977) zeigen.

Solche photopolymerisierbaren Bindemittel mit extrahierbaren bzw. diffusionsfähigen Verbindungen können jedoch im Lebensmittelverpackungssektor aus naheliegenden Gründen keine Anwendung finden.

Es wäre jedoch wünschenswert, gerade für diesen Anwendungsbereich ein Bindemittel zu haben, das die Vorteile der Photopolymerisation mit den Anforderungen an die Lebensmittelhygiene vereint.

Es hat nicht an Versuchen gefehlt, einpolymerisierbare Initiatoren zu entwickeln. In der Literatur werden z.B. Acrylsäurebenzoinester (Barzynski, Chem. Zeitung 96 (1972), S. 545) oder Umsetzungsprodukte aus Benzophenocarbonsäurederivaten mit Hydroxyäthyl(meth)acrylat (vgl. US-PS 4 004 998 und deutsche Offenlegungsschrift DE-OS 2 643 701) beschrieben.

Diese Verbindungen erweisen sich jedoch als nicht praxisgerecht, da sie einerseits nicht genügend reaktiv sind und/oder über keine ausreichende Dunkellagerstabilität verfügen.

Aus der US-PS 3 930 868 ist es ferner bekannt, Arylglyoxyloyloxyalkylacrylate herzustellen, die eine Arylglyoxyloylgruppe und ein (Meth)Acryloylgruppe, verbunden über einen Alkylendioxyrest, enthalten. Diese Arylglyoxyloyloxyalkyl(meth)acrylate werden zur Modifizierung (z.B. durch Pfropfen) von gesättigte oder noch ungesättigte Gruppen tragenden höhermolekularen Harzen herangezogen oder mit Monomeren zu höhermolekularen thermoplastischen Harzen in Gegenwart eines Katalysators compolymerisiert. Die erhaltenen Polymeren mit den lichtempfindlichen Arylglyoxyloylgruppierungen werden nach Aufbringen auf geeignete Substrate durch Lichteinwirkung an den belichteten Stellen in den unlöslichen Zustand überführt. Die Arylglyoxyloyloxyalkylacrylate der vorgenannten US-PS sind als Photoinitiatoren für ungesättigte Polyester (= UP-Harze) ungeeignet und lassen bei der Photopolymerisation von Acrylharzen bezüglich ihrer Reaktivität noch manche Wünsche Offen.

Schließlich ist es aus der deutschen Offenlegungsschrift DE-OS 2 639 742 bekannt, Arylglyoxylsäurester mit 1 bis 10 C-Atomen im Alkoholrest als Photoinitiatoren für photopolymerisierbare Monomere bzw. für Systeme aus ungesättigtem Polymer und Monomeren einzusetzen. Jedoch haben die vorgenannten Photoinitiatoren die gleichen Nachteile wie die der abgehandelten US-PS 3 930 868.

Aufgabe der vorliegenden Erfindung war es nun, UP-Harze gegebenenfalls in Abmischung mit photopolymerisierbaren Monomeren bzw. (Meth)Acryloylgruppen tragende Harze auf Polyepoxid- oder Polyurethanbasis gegebenenfalls in Abmischung mit photopolymerisierbaren Monomeren in kurzen Zeiten zu klebfreien, lösungsmittelfesten Überzügen mit Hilfe eines geeigneten Photoinitiators auszuhärten. Der einzusetzende Photoinitiator sollte keine verfärbten Produkte ergeben und nach der Photopolymerisation aus den vernetzten Überzügen durch physikalische Methoden nicht mehr entfernbar sein.

Die Aufgabe wurde dadurch gelöst, daß spezielle Photoinitiatoren entwickelt wurden, die minestens zwei (Meth)Acryloyloxygruppen und mindestens eine Arylglyoxyloyloxygruppe über einen mindestens drei- wertigen aliphatischen, gesättigten Kohlenwasserstoffrest, der durch Heteroatome bzw. Heteroatomgruppen unterbrochen sein kann, enthalten.

Gegenstand der Erfindung sind somit Verbindungen der allgemeinen Formel (I)

$$\left( R\text{-}Ar\text{-}\underset{\underset{O}{\Vert}}{C}\text{-}\underset{\underset{O}{\Vert}}{C}\text{-}O\text{-} \right)_m \; X \; \left( \text{-}O\text{-}\underset{\underset{O}{\Vert}}{C}\text{-}\underset{\underset{R_1}{|}}{C}=CH_2 \right)_n \qquad (I)$$

worin

Ar Phenyl oder Naphthyl, vorzugsweise Phenyl,

R Wasserstoff, Alkyl mit 1—4 C-Atomen, Alkoxy mit 1—4 C-Atomen, Halogen, vorzugsweise Chlor;
Dialkylamino mit 1—4 C-Atomen, vorzugsweise 1—2 C-Atomen in jedem Alkylgruppe,

Carboxy, Alkoxycarbonyl mit 1—4 C-Atomen in der Alkoxygruppe; insbesondere R = Wasserstoff;

X den 3 bis 6-wertigen, vorzugsweise 3 bis 4-wertigen, insbesondere 3-wertigen, um 3 bis 6 Hydroxylgruppen verminderten Rest eines 3 bis 6-wertigen, vorzugsweise 3 bis 4-wertigen, insbensondere 3-wertigen aliphatischen, gesättigten Alkohols oder eines vorgenannten Alkohols, dessen aliphatische Ketten durch mindestens eine der Gruppen

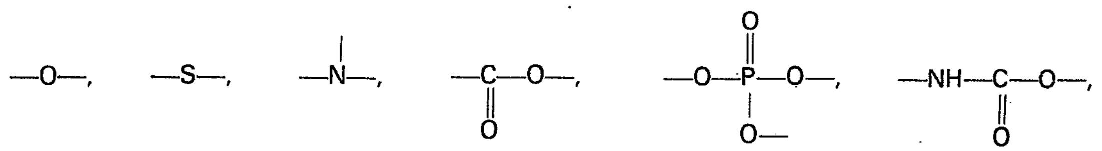

vorzugsweise 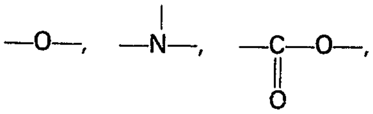

insbesondere —O— mindestens einmal unterbrochen (bzw. verknüpft) sind, die vorgenannten Alkohole haben OH-Zahlen von 100—1850;

$R_1$ Wasserstoff oder methyl

n eine Zahl von etwa 2 bis etwa 5, vorzugsweise etwa 2 bis etwa 3, insbesondere etwa 2 und

n + m eine Zahl von etwa 3 bis etwa 6, vorzugsweise 3 bis etwa 4, insbesondere etwa 3 bedeuten.

Aus der vorstehenden Formel I und den Definitionen für X, n und n + m folgt, daß jede der unter Formel I fallenden Verbindung — unabhängig von der Wertigkeit des Alkohols — mindestens zwei (Meth)Acryloyloxy — und mindestens einen Arylglyoxyloyloxyrest enthält.

Es folgt weiter, daß von vierwertigem Alkohol abgeleitete Verbindungen noch eine, von fünfwertigem Alkohol noch zwei und von sechswertigem Alkohol noch drei freie Hydroxylgruppen enthalten können. Für den Fall n + m = 4 und n = 2 sind zwei Arylglyoxyloyloxy- und zwei Acryloyloxyreste in der Verbindung der Formel I enthalten und für n + m = 6 und n = 2, vier Arylglyoxyloyloxy- und zwei (Meth)Acryloyloxygruppen.

Besonders bevorzugte Verbindungen der Formel I entsprechen der nachstehenden Formel (II)

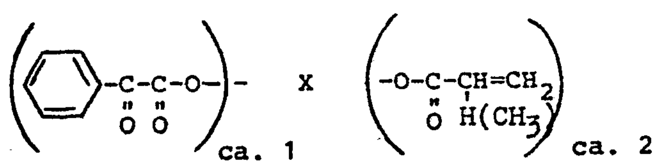

(II)

worin X den um die Hydroxylgruppen verminderten Rest des Trimethylolpropans oder den um die Hydroxylgruppen verminderten Rest eines oxäthylierten Trimethylolpropans mit einer OH-Zahl von 250 bis 600 bedeuten.

Die für die Herstellung der Verbindungen der Formel (I) einzusetzenden Arylglyoxylsäuren sind bekannt und lassen sich beispielsweise nach Verfahren gemäß "Methoden der Organischen Chemie" Houben-Weyl Bd. VIII (1952) S. 379, US-PS 3 532 737 und Beilstein, Handbuch der Organischen Chemie, 4. Auflage (1927) Bd. 10, Seiten 662, 663, 694, 695, 704, 713 und 745 sowie US—PS 3 065 259 herstellen.

Die Reste X leiten sich von 3 bis 6-wertigen aliphatischen gesättigten Alkoholen ab, die OH-Zahlen von etwa 100 bis ca. 1850 (mgKOH pro Gramm Substanz) besitzen können.

A) Beispielhaft seien genannt 1,1,1-Trimethylolpropan (= Trimethylolpropan), Glycerin, 1,1,1-Trimethyloläthan, 1,2,6-Hexantriol, Pentaerythrit, Dipentaerythrit, Sorbit, Mannit und die Oxalkylierungsprodukte vorstehender Alkohole mit 1,2-Alkylenoxiden, vorzugsweise mit 1—10, insbesondere 1—2 Mol 1,2-Alkylenoxid pro Hydroxylgruppe. Als 1,2-Alkylenoxide kommen z.B. Äthylenoxid, Propylenoxid, Butylenoxid oder Mischungen von zwei oder mehr Komponenten in Frage.

Besonders bevorzugt sind Oxäthylierungsprodukte des Trimethylolpropans mit einer OH-Zahl von 250—600 und das Trimethylolpropan selbst.

Die mehrwertigen Alkohole können neben Kohlenstoff, Wasserstoff und Sauerstoff auch andere Atome oder Atomgruppen wie

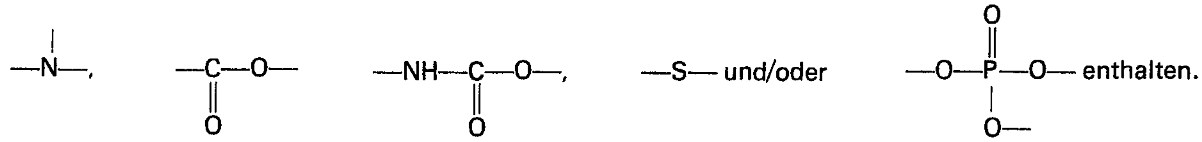

und/oder enthalten.

B) Stickstoffhaltige, 3-6-wertige aliphatische Alkohole können beispielsweise sein: Triäthanolamin, Triisopropanolamin, Oxalkylierungsprodukte der vorstehenden Alkohole oder von aliphatischen Aminoverbindungen mit 3 bis 6 aktiven Aminowasserstoffatomen mit 1,2-Alkylenoxiden. Derartige Aminoverbindungen sind beispielsweise Polyamine wie Äthylendiamin, Diäthylentriamin, Triäthylentetramin, Tetramethylendiamin, Hexamethylendiamin, Dihydroxy-tert.-butylamin, Trihydroxy-tert.-butylamin, weiter Ätheramine wie Diaminodialkyläther, Polyalkylenglykolpoläther-di- und triamine (z.B. $H_2N$-[alkylen-O]$_x$alkylen-$NH_2$, x = 3—10).

C) Oxycarbonylamino-gruppen (—O—CO—NH—) enthaltende 3-6-wertige aliphatische Alkohole können aus 4-6-wertigen aliphatischen Alkoholen mit aliphatischen Monisocyanaten, oder aus mindestens 3-wertigen Alkoholen, Ätheralkoholen, tert.-Stickstoff oder Thiogruppen enthaltenden Alkoholen bzw. Ätheralkoholen mit aliphatischen Diisocyanaten erhalten werden. Die Isocyanate selbst können auch Umsetzungsprodukte aus Glykolen, Polyätherglykolen, Polyesterätherglykolen oder Thioätherglykolen mit in Bezug auf die Hydroxylgruppen überschüssigen eingesetzten aliphatischen Di- und Polyisocyanaten sein. Besitzen die so erhaltenen Isocyanate mindestens drei Isocyanatgruppen pro Moleküle, so können auch zwei- wertige Alkohole gegebenenfalls mit —S—,

$$-\overset{|}{N}-,$$

—O-Gruppen zur Herstellung der 3-6-wertigen, Oxycarbonylaminogruppen enthaltende Alkohole herangezogen werden.

D) Weiter ist es möglich, Oxalkylierungsprodukte der o-Phosphorsäure mit 3—30, vorzugsweise 3—6 Mol 1,2-Alkylenoxiden, insbensondere Äthylenoxid pro Mol o-Phosphorsäure als 3-wertige Alkohole zur Herstellung der erfindungsgemäßen Verbindungen einzusetzen.

E) Dem Reste X zugrundeliegende 3-6-wertige aliphatische, gesättigte Alkohole können auch Veresterungsprodukte der unter A) genannten 3-6-wertigen Alkohole bzw. Atheralkohole mit aliphatischen Mono-, Di-, Tri- und Tetracarbonsäuren sein, die ihrerseits noch Hydroxylgruppen enthalten können, wobei Mono- carbonsäuren, soweit sie keine Hydroxylgruppen enthalten, natürlich nur mit solchen Polyolen und Polyätherpolyolen und in solchen Mengen eingesetzt werden dürfen, daß das Endprodukt 3-6 OH-Gruppen enthält. Als Säuren seien beispielhaft genannt: Essigsäure, Propionsäure, Glykolsäure, Glycerinsäure, Citronensäure, Weinsäure, Schleimsäure, Bernsteinsäure, Glutarsäure, Adipinsäure, Thiobisessigsäure usw.

F) Ferner kann man durch Oxalkylierung von Thioalkoholen wie Thioglycerin und von Aminocarbonsäuren wie Aminoessigsäure, 3-Aminopropionsäure, 4-Aminobuttersäure, von Citronensäure, Weinsäure, Glycerinsäure, Schleimsäure (Oxalkylierung der Thio-, Amino-, Carboxyl- und gegebenenfalls der Hydroxylgruppe) zu erfindungsgemäß einzusetzenden 3-6-wertigen Alkoholen gelangen.

Die Herstellung der Verbindungen der allgemeinen Formel (I) erfolgt nach bekannten Veresterungsverfahren. Obwohl es prinzipiell möglich ist, durch Umsetzung der Säurechloride und der Säureanhydride der Arylglyoxyl- und Acrylsäure in Gegenwart geeigneter Katalysatoren wie tert.-Amine oder durch Umsetzung der Ester (wie Methyl- und Äthylester) der Arylglyoxyl- und (Meth)Acrylsäure in Gegenwart metallorganischer Verbindungen wie Titantetraalkylaten oder Aluminiumalkoholaten bzw. Alkalialkoholaten als Katalysatoren mit den 3-6-wertigen Alkoholen zu den Verbindungen der Formel (I) zu gelangen, erfolgt die Veresterung bevorzugt durch direkte Veresterung der Arylglyoxylsäuren bzw. (Meth)acrylsäure mit den 3-6-wertigen Alkoholen in Gegenwart katalytischer Mengen von Mineralsäuren oder organischen Sulfonsäuren wie p-Toluolsulfonsäure. Dabei kann die Verfahrensweise so gewählt werden, daß das Endprodukt in 2 Schritten erhalten wird, d.h. zunächst die Veresterung oder Umesterung mit (Meth)Acryl- bzw. Arylglyoxylsäure und anschließend die Umsetzung mit der noch fehlenden Komponente. Es kann jedoch auch in einer bevorzugten Ausführungsform die Reaktion im Eintopfverfahren durchgeführt werden, in der Weise, daß alle an der Reaktion beteiligten Komponenten synchron zur Reaktion gebracht werden. Die Veresterung erfolgt bevorzugt bei Temperaturen von 60—150°C.

Die Veresterung kann in Abwesenheit oder in Gegenwart indifferenter Lösungsmittel wie Benzol, Toluol, Xylol, Chlorbenzol, n-Hexan, Cyclohexan, Methylenchlorid, Chloroform usw. durchgeführt werden.

Eine bevorzugte Ausführungsform in die azeotrope Veresterung mit Toluol als Schleppmittel und p-Toluolsulfonsäure als Katalysator.

Die einzusetzenden Mengen an Arylglyoxylsäure und (Meth)Acrylsäure richten sich nach der Wertigkeit des Alkohols und dem gewünschten Endproduckt. Bedingung ist lediglich, daß das Endprodukt der Formel (I) stets polyfunktionell (mindestens etwa difunktionell) in Bezug auf die (Meth)Acryloyloxygruppen und gleichzeitig stets mindestens monofunktionell bezüglich der Arylglyoxyloyloxygruppen ist. Daraus folgt, daß dreiwertige Alkohole (1 Mol) stets mit etwa 2 Mol (Meth)Acrylsäure und etwa 1 Mol Arylglyoxylsäure verestert werden. Im Falle der vierwertigen Alkohole können pro Mol Alkohol etwa 2 bis 3 Mol (Meth)Acrylsäure und etwa 1—2 Mol Arylglyoxylsäure

eingesetzt werden. Fünfwertige Alkohole (1 Mol) können mit etwa 2—4 Mol (Meth)Acrylsäure und etwa 1—3 Mol Arylglyoxylsäure bzw. 6-wertige Alkohole mit etwa 2—5 Mol (Meth)Acrylsäure und etwa 1 bis 4 Mol Arylglyoxylsäure verestert werden.

Um die polymerisierbaren erfindungsgemäßen Reaktionsprodukte vor unerwünschter vorzeitiger Polymerisation zu bewahren, empfiehlt es sich, bereits bei der Herstellung 0,001—0,15 Gew.-%, bezogen auf die Gesamtmischung, an Polymerisationsinhibitoren oder Antioxydantien zuzusetzen.

Geeignete Hilfsmittel dieser Art sind beispielsweise Phenole und Phenolderivate, vorzugsweise sterisch gehinderte Phenole, die in beiden o-Stellungen zur phenolischen Hydroxygruppe Alkylsubstituenten mit 1—6 C-Atomen, enthalten, Amine, vorzugsweise sekundäre Arylamine und ihre Derivate, Chinone.

Namentlich seien genannt: 4,4' - Bis - (2,6 - di - tert. - butyl - phenol), 1,3,5 - Trimethyl - 2,4,6 - tris - (3,5 - di - tert. - butyl - 4 - hydroxy - benzyl) - benzol, 4,4' - Butyliden - bis - (6 - tert. - butyl - m - kresol), 3,5 - Di - tert. - butyl - 4 - hydroxybenzyl - phosphonsäurediäthylester, N,N' - Bis - (β - naphthyl) - p - phenylen - diamin, N,N' - Bis - (1 - methylheptyl) - p - phenylendiamin, Phenyl - β - naphthylamin, 4,4' - Bis- (α,α - dimethylbenzyl) - diphenylamin, 1,3,5 - Tris - (3,5 - di - tert. - butyl - 4 - hydroxy - hydrochinnamoyl) - hexahydro - s - triazin, Hydrochinon, p - Benzochinon, 2,5 - Di - tert. - butylchinon, Toluhydrochinon p - tert. - butyl - brenzcatechin, 3 - Methylbrenzcatechin, 4 - Äthylbrenzcatechin, Chloranil, Naphthochinon, Phenothiazin, 2,5 - Di - tert. - butyl - hydrochinon.

Weitere geeignete Stabilisatoren sind in "Methoden der organischen Chemie" (Houben-Weyl), 4. Auflage, Band XIV/1, S. 433—452, Georg Thieme Verlag, Stuttgart, 1961, beschrieben. Sehr gut geeignet ist z.B. 2,5-Di-tert.-butyl-hydrochinon, oder Toluhydrochinon in einer Konzentration von 0,001 bis 0,15 Gew.-%, bezogen auf polymerisierbare Gesamtmischung.

Gegenstand der Erfindung ist auch die Verwendung der Verbindungen der Formel (I) als Initiatoren für die Photopolymerisation olefinisch ungesättigter, photopolymerisierbarer monomerer oder oligomerer Verbindungen (Harze) oder deren Mischungen.

Ferner sind die photopolymerisierbaren Mischungen selbst, die als Bindemittel in Überzugsmitteln und Druckfarben zum Einsatz gelangen können, Gegenstand der vorliegenden Erfindung.

Die vorgenannten photopolymerisierbaren Bindemittel sind Mischungen aus

A) 20—95 Gew.-% mindestens eines photopolymerisierbaren, mehr als eine olefinisch ungesättigte C—C-Doppelbindung enthaltenden Harzes aus der Gruppe der 1,2-Polyepoxide, der Polyester und Polyurethane,

B) 0—75 Gew.-% mindestens eines Acrylsäure- oder Methacrylsäureesters von ein- bis vierwertigen Alkoholen oder Styrol oder deren Mischungen, und

C) 5—80 Gew.-% mindestens eines Photoinitiators,

dadurch gekennzeichnet, daß die Mischung als Photoinitiator mindestens eine Verbindung der allgemeinen Formel (I) enthält.

Vorzugsweise sind olefinisch ungesättigte C—C-Doppelbindungen aufweisende 1,2-Polyepoxide und Polyurethane, d.h. 1,2-Polyepoxy(meth)acrylate und Polyurethan(meth)acrylate in den Mischungen als Komponente A enthalten. Die Epoxidgruppen der Polyepoxide bzw. die OH-Gruppen enthaltenden Polyurethane sind ganz oder teilweise (mindestens 60%) mit Acrylsäure oder Methacrylsäure verestert worden. In den Polyestern sind die ungesättigten Gruppen, vorzugsweise als 2-Butendioylidioxy-Gruppen, (—O—CO—CH=CH—CO—O—; (cis- und trans) enthalten.

Die vorstehend unter A) angegebenen Harze sind bekannt, ebenso ihre Mischungen mit Komponente B). Derartige Mischungen wurden bereits mit üblichen bekannten Photoinitiatoren gehärtet.

Polyepoxy(meth)acrylate, die in den erfindungsgemäßen Bindemitteln als Mischungskomponente vorhanden sind, sind beispielsweise in der US-PS 4 014 771, GB-PS 1 456 486, DE-OS 2 534 012, US-PS 4 049 745 beschrieben. Sie stellen Umsetzungsprodukte aus 1,2-Polyepoxiden mit mehr als einer 1,2-Epoxidgruppe pro Molekül mit Acrylsäure oder Methacrylsäure dar, wobei auf eine Epoxidgruppe etwa 0,6 bis 1 Mol (Meth)Acrylsäure eingesetzt worden sind. Besonders Bevorzugt sind Polyepoxide von Polyphenolen, insbesondere vom Bisphenol A. Vor ihrer Umsetzung mit Acrylsäure oder Methacrylsäure können die Polyepoxide mit Ammoniak, aliphatischen oder cycloaliphatischen primären oder sekundären Aminen modifiziert worden sein und gegebenenfalls nach der Umsetzung mit (Meth)Acrylsäure noch mit einer gesättigten aliphatischen Carbonsäure umgesetzt worden sein. Auch ist es möglich, die Polyepoxide zunächst teilweise mit Schwefelwasserstoff, Dithiolen oder Polythiolen zu verlängern und dann mit Acrylsäure oder Methacrylsäure in Polyepoxy(meth)acrylate zu überführen. Einzelheiten können den vorstehend genannten Schriften entnommen werden, in denen auch Mischungen der Polyepoxy(meth)acrylate mit mono- und polyfunktionellen Acrylsäureestern oder Methacrylsäureestern offenbart sind.

Polyurethan(meth)acrylatharze sind beispielsweise in US-PS 3 297 745, DE-OS 1 644 797, DE-OS 2 102 383, DE-OS 2 557 408 und US-PS 3 782 961 beschrieben.

Ungesättigte Polyester (UP-Harze) sind ebenfalls lange bekannt, beispielsweise aus den

deutschen Offenlegungsschriften 2 411 637, 2 244 171, 2 221 335, DE-AS 1 024 654 und Kunststoff Handbuch Bd. VIII, Polyester, S. 247—312 (1973), Verlag Carl Hanser, München.

Die Arylglyoxyloyloxyalkyl(meth)acrylate der allgemeinen Formel I können, wie bereits ausgeführt, auch zur Photopolymerisation olefinisch ungesättigter Monomorer verwendet werden.

Solche Monomers sind beispielsweise:

1) Ester der Acryl- oder Methacrylsäure mti aliphatischen $C_1$—$C_8$, cycloaliphatischen $C_5$—$C_6$, araliphatischen $C_7$—$C_8$ Monoalkoholen beispielsweise Methylacrylat, Äthylacrylat, n-Butylacrylat, Methylhexylacrylat, 2-Äthylhexylacrylat und die entsprechenden Methacrylsäureester; Cyclopentylacrylat; Cyclohexylacrylat oder die entsprechenden Methacrylsäureester; Benzylacrylat, β-Phenyläthylacrylat und entsprechende Methacrylsäureester;

2) Hydroxyalkylester der Acryl- oder Methacrylsäure mit 2—4 C-Atomen in der Alkoholkomponente, wie Hydroxy-äthylacrylat, 2-Hydroxypropylacrylat, 3-Hydroxypropylacrylat, 2-Hydroxybutylacrylat, 3-Hydroxybutylacrylat oder entsprechende Methacrylsäureester;

3) Di- und Polyacrylate sowie Di- und Polymethacrylate von Glykolen mit 2 bis 6 C-Atomen und Polyolen mit 3—4 Hydroxylgruppen mit 3 bis 6 C-Atomen, wie Äthylenglykoldiacrylat, Propandiol-1,3-diacrylat, Butandiol-1,4-diacrylat, Hexandiol-1,6-diacrylat, Trimethylolpropantriacrylat, Pentaerythirittri- und -tetraacrylat sowie entsprechende Methacrylate, ferner Di-(meth)-acrylate von Polyätherglykolen des Glykols, Propandiol-1,3, Butandiol-1,4; Trimethylolpropan, Pentaerythrit.

4) N-Methylolacrylamid oder N-Methylolmethacrylamid sowie entsprechende N-Methylolalkyläther mit 1—4 C-Atomen in der Alkyläthergruppe bzw. entsprechende N-Methylolallyläther, insbesondere N-Methoxymethyl(meth)acrylamid, N-Butoxymethyl(meth)acrylamid und N-Allyloxymethyl(meth)acrylamid;

5) Styrol, Divinylbenzol.

Es können auch Gemische aus einem oder mehreren der vorgenannten Monomeren eingesetzt werden.

Die Monomeren der Gruppen 1), 3) und Styrol werden vorzugsweise als Komponente B zur Abmischung mit Komponente A) in den erfindungsgemäßen photopolymerisierbaren Bindemitteln eingesetzt.

Obwohl es bevorzugt ist, die erfindungsgemäßen Bindemittel in lösungsmittelfreien, UVhärtenden Überzugsmitteln einzusetzen, ist es möglich, eine geeignete Viskosität durch Abmischen mit inerten Lösungsmitteln wie Butylacetat, Äthylacetat, Aceton, Äthylmethylketon, Diäthylketon, Cyclohexan, Cyclohexanon, Cyclopentan, Cyclopentanon, n-Heptan, n-Hexan, n-Octaon, Isooctan, Methylenchlorid, Chloroform, 1,1-Dichloräthan, 1,2-Dichloräthan, 1,1,2-Trichloräthan, Tetrachlorkohlenstoff einzustellen. Um eine solche verarbeitungsgerechte Viskosität zu erhalten, können 5 bis 50 Gew-%, vorzugsweise 20 bis 40 Gew.-%, an Lösungsmitteln, bezogen auf Mischung aus erfindungsgemäßem Reaktionsprodukt und Lösungsmittel, zugesetzt werden.

Dabei ist darauf zu achten, daß in einer fertigen Lackformulierung der Anteil an dem erfindungsgemäßen comonomeren Photoinitiator so gewählt ist, daß in dem Überzugsmittel genügend Reaktivität vorhanden ist, d.h. mindestens 0,02 Mol Arylglyoxylsäure/100 g Bindemittel.

Als Strahlenquellen zur Durchführung der Photopolymerisation können künstliche Strahler, deren Emission im Bereich von 2500—5000 Å, vorzugsweise 3000—4000 Å, liegt, verwendet werden. Vorteilhaft sind Quecksilberdampf-, Xenon- und Wolfram-Lampen, insbesondere Quecksilberhochdruckstrahler.

In der Regel lassen sich Schichten der erfindungsgemäßen Reaktionsprodukte mit einer Dicke zwischen 1 μm und 0,1 mm (1 $\mu m = 10^{-3}$ mm) in weniger als einer Sekunde zu einem Film aushärten, wenn sie mit dem Licht einer ca. 8 cm entfernten Quecksilberhochdrucklampe, beispielsweise vom Typ HTQ-7 der Firma Philips, bestrahlt werden.

Werden Füllstoffe bei der Verwendung der erfindungsgemäßen Harzmassen als UV-Licht-härtende Überzüge mitverwendet, so ist deren Einsatz auf solche beschränkt, die durch ihre Absorptionsverhalten den Polymerisationsvorgang nicht unterdrücken. Beispielsweise können Talkum, Schwerspat, Kreide, Gips, Kieselsäuren, Asbestmehle und Leichtspat als lichtdurchlässige Füllstoffe verwendet werden, in sehr dünnen Schichten können auch $TiO_2$ oder andere Farbpigmente mitverwendet werden.

Das Auftragen der Überzugsmittel auf geeignete Substrate kann mittels in der Lackindustrie üblichen Methoden wie Sprühen, Walzen, Rakeln, Drucken, Tauchen, Fluten, Streichen, Pinseln erfolgen.

Geeignete Substrate sind Papier, Karton, Leder, Holz, Kunststoffe, Textilien, keramische Materialien, Metalle, vorzugsweise Papier und Karton. Da die Überzugsmittel unter UV-Licht in Sekundenbruchteilen bis zu wenigen Sekunden zu Filmen mit ausgezeichneten mechanischen Eigenschaften aushärten, ist es beispielsweise möglich, einen Papierbeschichtungsvorgang den in der Druckbranche üblichen Verarbeitungsgeschwindigketien anzupassen.

Die in den Beispielen angegebenen Prozente und Teile beziehen sich auf das Gewicht, sofern nicht anders vermerkt.

Beispiel 1

Herstellung eines erfindungsgemäßen Initiators

100 g eines oxäthylierten Trimethylolpropans (OH-Zahl 550=0,98 OH-Äquivalente pro 100 g) werden mit 50 g Phenylglyoxylsäure (1/3 Mol) und 43 g Acrylsäure (ca. 0,6 Mol) in 300 ml Toluol gelöst. Unter Zugabe von 4,3 g p-Toluolsulfonsäure und 0,2 g Toluhydrochinon wird unter Durchleiten von Luft so lange azeotrop verestert (t = 110—115°C), bis die SZ des Ansatzes 5 ist. SZ = Säurezahl.

Dann wird das Toluol im Vakuum abdestilliert und unter Durchleiten von Luft 2 Std. bei 100°C/30 mbar die letzten Spuren von Toluol und sonstige flüchtige Bestandteile entfernt.

Es resultierte eine helle Flüssigkeit mit einer Viskosität von 800 mPa.sec/20°C, die aufgrund des IR-Spektrums, der Elementaranalyse, der Verseifungs- und Jodzahl und des Molgewichts als Verbindung der Formel

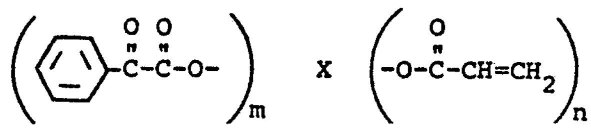

X

worin

m etwa 1, n etwa 2 und X den um die Hydroxylgruppen verminderten Rest eines oxäthylierten Trimethylolpropans (OH-Zahl 550) darstellt, identifiziert wurde.

Beispiel 2

Herstellung eines Vergleichsinitiators (entsprechend US-PS 3 930 868)

170 g Phenylglyoxylsäurechlorid werden mit 120 g Hydroxyäthylacrylat in 400 ml Diäthyläther umgesetzt. Anschließend werden 80 g Triäthylamin in 300 ml Äther zugetropft. Nach Beendigung der Reaktion wird der Ansatz über Nacht stehengelassen, mit Wasser neutral gewaschen, getrocknet, mit 0,1 g Toluhydrochinon stabilisiert, über $SiO_2$ filtriert und der Äther abdestilliert. Es resultiert eine helle Flüssigkeit (Phenylglyoxyloyloxyäthylacrylat) mit einer Viskosität von 200 mPa.sec/20°C.

Beispiel 3

Herstellung eines Vergleichsinitiators (entsprechend DE-OS 2 639 742)

150 g Phenylglyoxylsäure werden mit 40 g Methanol in üblicher Weise zu Phenylglyoxylsäuremethylester umgesetzt. $Kp_{0,9}$ 80—82°C, $n_D^{20}$: 1,5294.

Beispiele 4—6

Herstellung von photopolymerisierbaren Harzen (Komponente A)

Beispiel 4

Ein ungesättigter Polyester wird bei 160—180°C durch Schmelzkondensation von 2320 g Fumarsäure, 451 g Propylenglykol, 1440 g Diäthylenglykol, 940 g Trimethylolpropandiallyläther sowie 430 g Diäthylenglykolmonobutyläther in üblicher Weise hergestellt. Das Polyesterharz wird 69%ig in Styrol gelöst.

Beispiel 5

340 g eines Bisphenol A-bisglycidyläthers (Epoxyäquivalentgewicht 190) werden mit 13 g Diäthanolamin sowie 8 g Äthanolamin bei 30°C innerhalb 3 Std. umgesetzt. Anschließend wird bei 60°C mit 80 g Acrylsäure versetzt und bis zur SZ O gerührt (insgesamt ca. 8 Std.). Es wird mit 440 g eines Triacrylates eines oxäthylierten Trimethylolpropans mit einer Oh-Zahl von 550 abgemischt.

Beispiel 6

Ein Urethanacrylat wird bei 40°C innerhalb von 6 Std. hergestellt durch Umsetzung von 417 g Toluylendiisocyant mit 36 g Thiodiglykol sowie 670 g eines äthoxylierten Trimethylolpropans (OH-Zahl 250) und anschließend mit 220 g 2-Hydroxyäthylacrylat. Das Urethanacrylat wird mit 300 g eines Triacrylates eines oxäthylierten Trimethylolpropans (OH-Zahl 550) abgemischt.

Vergleich der Initiatoren gemäß der Beispiele 1—3

Dazu wurde so verfahren, daß nach Abmischung der Initiatoren gemäß den Beispielen 1—3 mit den Bindemitteln der Beispiele 4—6 die Initiatorkonzentration in den Bindemitteln 0,03 Mol-%, bezogen auf Phenylglyoxyloyloxyrest, beträgt, um einen eindeutigen Vergleich zu ermöglichen. Im einzelnen wurden — stets auf 100 g UV-härtbare Mischung bezogen — die aus Tabelle 1 ersichtlichen Mengen eingesetzt.

Tabelle 1
Hergestellte Mischungen

| Mischung | A | B | C |
|---|---|---|---|
| je 18 g Initiator nach den Beispielen | 1 | 1 | 1 |
| je 82 g Harz nach den Beispielen | 4 | 5 | 6 |

| Mischung | D | E | F |
|---|---|---|---|
| je 7,5 g Initiator nach den Beispielen | 2 | 2 | 2 |
| je 92,5 g Harz nach Beispielen | 4 | 5 | 6 |

| Mischung | G | H | I |
|---|---|---|---|
| je 5,3 g Initiator nach Beispielen | 3 | 3 | 3 |

| Mischung | G | H | I |
|---|---|---|---|
| je 94,7 g Harz nach den Beispielen | 4 | 5 | 6 |

Es wurden die Mischungen A, D, G; B, E, H; C, F, I jeweils miteinander hinsichtlich ihrer Reaktivität verglichen.

Vergleich A, D, G

Von den Mischungen A, D, G wurde jeweils ein 500 $\mu$m dicker Film auf eine Glasplatte gezogen und mit einer aktinischen Leuchtstoffröhre vom Typ TL-AK 40 (Fa. Philips) belichtet.

Ergebnis:

Mischung A war nach 15 min. klebfrei und staubtrocken ausgehärtet. Mischung D und G zeigten nach dieser Zeit noch keine Anzeichen von Polymerisation. Die Filme waren naß.

Hieraus geht hervor, daß nur der erfindungsgemäße Initiator (in Mischung A) in styrolisierten UP-Harzen aktiv ist, während die übrigen Phenylglyoxylsäurederivate keine Polymerisationsneigung erkennen ließen.

Vergleich der Mischungen B, E, H und C, F, I

Die Mischungen wurden wie folgt geprüft:

Es wurde mit einem Spiralrakel ein jeweils 20 $\mu$m dicker Film auf weißes Papier gezogen. Die Aushärtung erfolgte mit einem Hanovia-Strahler (80 Watt/cm Strahlerleistung) im Abstand von 10 cm auf einem mit regelbarer Geschwindigkeit ausgestatteten Transportband. Die Bandgeschwindigkeit in m/min. bis zur vollständigen Aushärtung (klebfrei und lösungsmittelfest) ist dabei ein Maßstab für die unterschiedliche Reaktivität.

Tabelle 2
Verwendete Zusammensetzung und Überprüfung der Reaktivät

| Mischung | Reaktivität (m/min) |
|---|---|
| B erfindungsgemäß | 35 |
| E Vergleich | 20 |
| H „ | 20 |
| C erfindungsgemäß | 25 |
| F Vergleich | 10 |
| I „ | 10 |

Beispiel 7

Es wird bei 110—120°C ein einbaubarer Photoinitiator hergestellt durch azeotrope Veresterung von 134 g Trimethylolpropan (1 Mol) mit 140 g Acrylsäure (1,94 Mol) und 150 g Phenylglyoxylsäure (1 Mol) in 500 ml Toluol als Schleppmittel, 0,4 g Toluhydrochinon als Stabilisator und 4 g p-Toluolsulfonsäure als Katalysator. Nach Beendigung der Reaktion (8 Std.) wird der Ansatz wie in Beispiel 1 aufgearbeitet. Es resultiert ein harzartiges Produkt mit einer Viskosität von 2 Pa.sec/20°C und einer Säurezahl von < 5. Der Verbindung kann aufgrund des IR-Spektrums, der Elementaranalyse, der Verseifungszahl und des Molgewichtes die Formel des Monophenylglyoxylsäure-/diacrylsäureesters des Trimethylolpropans zugeordnet werden, d.h. in der allgemeinen im Test angegebenen Formel (I) ist n etwa 2, m etwa 1 und X der um die Hydroxylgruppen verminderte Rest des Trimethylolpropans.

Beispiel 8

Es werden 670 g (= 2,99 OH-Äquivalente in Gramm) eines oxäthylierten Trimethylolpropans (OH-Zahl 250) mit 140 g Acrylsäure (1,94 Mol) und 150 g Phenylglyoxylsäure (1 Mol) analog Beispiel 7 umgesetzt und aufgearbeitet. Die resultierende Flüssigkeit hat eine Viskosität von 400 mPa.sec/20°C und eine Säurezahl von < 5. Die Verbindung entspricht der allgemeinen Formel (I) in der n etwa 2, m etwa 1 und x den um die OH-Gruppen verminderten Rest eines oxäthylierten Trimethylolpropans mit der OH-Zahl 250 bedeuten.

Beispiel 9

85 g des Harzes nach Beispiel 5 werden mit 15 g erfindungsgemäßen Initiators nach Beispiel 7 vermischt und anschließend als 20 $\mu$m Film auf weißem Papier in der vorbeschriebenen Weise ausgehärtet. Ergebnisse siehe Tabelle 3.

Beispiel 10

70 g des Harzes nach Beispiel 5 werden mit 30 g des erfindungsgemäßen Initiators nach Beispiel 8 vermischt und ebenfalls als 20 $\mu$m Film auf weißes Papier in der vorbeschriebenen Weise ausgehärtet. Ergebnisse siehe Tabelle 3.

Tabelle 3
Reaktivität von erfindungsgemäßen Initiatoren

| Beispiel | Reaktivität (m/min) |
|---|---|
| 9 | 35 |
| 10 | 30 |

Beispiel 11

Es werden 725 g wines propoxylierten Sorbits (OH-Zahl 450) mit 150 g Phenylglyoxylsäure (1 Mol) und 150 g Acrylsäure (2,09 Mol) azeotrop analog Beispiel 1 verestert und aufgearbeitet.

Das nach der Aufarbeitung resultierende Produkte hat eine Viskosität von 12 Pas und eine OH-Zahl von 170 und eine Säurezahl von 3.

Als selbstvernetzendes Bindemittel erreicht die Verbindung nach Beispiel 1 als 20 $\mu$m Film auf Papier unter zuvor beschriebenen Bedingungen eine Reaktivät von 15 m/min.

Beispiel 12

354 g Toluylendiisocyanat werden mit 220 g Hydroxyäthylacrylat und 0,2 ml Zinnoctoat umgesetzt. Nach Erreichen eines NCO-Werts von 15,8 % wird mit 36 g Thiodiglykol 400 g eines oxäthylierten Trimethylolpropans (OH-Zahl 250) sowie 400 g der Verbindung nach Beispiel 11 umgesetzt. Es resultiert eine selbstvernetzendes Urethanacrylat-Harz, das nach Abmischung mit 200 g Hexandiol-1,6-diacrylat eine Viskosität 200 Pas hat und als 20 μm Film auf Papier unter den zuvor beschriebenen Bedingungen eine Reaktivität von 30 m/min erreicht.

Beispiel 13

100 g eines oxäthylierten Trimethylolpropans (OH-Zahl 550) werden mit 65 g (ca. 0,3 Mol) 3,4-Methylendioxyphenylglyoxylsäure und 43 g (ca. 0,6 Mol) Acrylsäure analog Beispiel 1 azeotrop verestert und aufgearbeitet.

Es resultierte eine helle Flüssigkeit mit einer Viskosität 1200 mPas/20°C und einer Säurezahl von 3.

Ergebnisse s. Tabelle 4.

Beispiel 14

100 g eines oxäthylierten Trimethylolpropans (OH-Zahl 550) werden mit 70 g (ca. 0,33 Mol) 3,4-Di-methoxyphenylglyoxylsäure und 43 g (ca. 0,6 Mol) Acrylsäure analog Beispiel 1 verestert und aufgearbeitet.

Es resultiert eine helle Flüssigkeit mit einer Viskosität von 1200 mPas/20°C und einer Säurezahl 2.

Ergebnisse siehe Tabelle 4.

Beispiel 15

Es wird analog Beispiel 14 verfahren mit der Änderung, daß statt 70 g 3,4-Dimethoxyphenylglyoxylsäure 61 g 3-Chlorphenylglyoxylsäure eingesetzt werden. Es resultiert eine helle Flüssigkeit mit einer Viskosität von 500 mPas/20°C und einer Säurezahl von 3.

Ergebnisse siehe Tabelle 4.

Beispiel 16.

Es wird analog den vorangegangenen Beispielen verfahren mit der Änderung, daß als Glyoxylsäurederivat 92 g (0,3 Mol) 4,7-Dinitro-naphthylglyoxylsäure-1 eingesetzt werden.

Es resultiert eine helle Flüssigkeit mit einer Viskosität von 1100 mPas/20°C und einer Säurezahl von 4.

Ergebnisse siehe Tabelle 4.

Beispiel 17

Es wird ein Phenylglyoxylmethacrylsäureester hergestellt durch Umsetzung von 100 g eines äthoxylierten Trimethylolpropans (OH-Zahl 550) mit 50 g Phenylglyoxylsäure und 50 g ca. (0,6 Mol) Methacrylsäure analog Beispiel 1.

Nach Aufarbeitung resultierte eine helle Flüssigkeit mit einer Viskosität von 900 mPas/20°C und einer Säurezahl von 0,5. Ergeb nisse siehe Tabelle 4.

Tabelle 4

Je 20 g der Initiatoren nach Beispiel 13 bis 17 werden mit 80 g des Harzes nach Beispiel 5 vermischt und die Reaktivität als 20 μm Film auf Papier wie vorbeschrieben geprüft.

Ergebnisse:

| Initiator Bsp. | Reaktivität m/min |
|---|---|
| 13 | 25 |
| 14 | 20 |
| 15 | 28 |
| 16 | 15 |
| 17 | 25 |

**Patentansprüche**

1. Verbindungen der allgemeinen Formel (I)

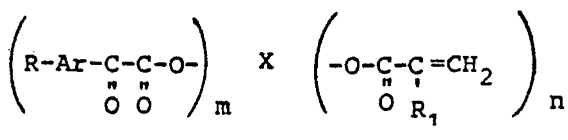

(I)

worin

Ar Phenyl oder naphthyl

R Wasserstoff, Alkyl mit 1—4 C-Atomen, Alkoxy mit 1—4 C-Atomen, Halogen, Dialkylamino mit 1—4 C-Atomen in jeder Alkylgruppe, Carboxy, Alkoxycarbonyl mit 1—4 C-Atomen in der Alkoxygruppe,

X den 3—6-wertigen Rest eines um 3—6 Hydroxylgruppen verminderten 3—6-wertigen, aliphatischen, gesättigten Alkohols oder eines vorgenannten Alkohols, dessen aliphatische Ketten durch mindestens eine der Gruppen

—O—, —S—, 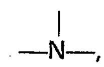, 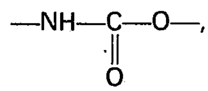, 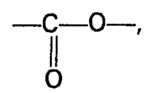, 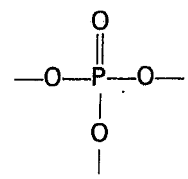

mindestens einmal unterbrochen oder verknüpft sind — die vorgenannten Alkohole besitzen OH-Zahlen von 100 bis 1850 —

$R_1$ Wasserstoff oder Methyl

n eine Zahl von etwa 2 bis etwa 5 und

n + m eine Zahl von etwa 3 bis etwa 6 bedeuten.

2. Verbindungen gemäß Formel (I) des Anspruchs 1; worin Ar Phenyl, R Wasserstoff, X den 3—6-wertigen Rest eines um 3—6 Hydroxylgruppen verminderten 3—6-wertigen, aliphatischen, gesättigten Alkohols oder eines vorgenannten Alkohols, dessen aliphatische Ketten durch mindestens eine der Gruppen

—O—, 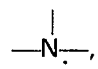, 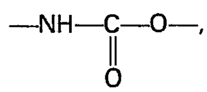, 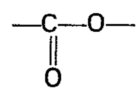

mindestens einmal unter brochen oder verknüpft sind — die vorgenannten Alkohole besitzen OH-Zahlen von 100 bis 1850 — n eine Zahl von etwa 2 bis etwa 5 und n + m eine Zahl von etwa 3 bis 6 bedeuten.

3. Verbindungen gemäß Anspruch 2, worin die aliphatischen Ketten des Alkohols mindestens einmal durch die Gruppe —O— unterbrochen sind.

4. Verbindungen gemäß Formel (I) des Anspruchs 1, worin Ar Phenyl R Wasserstoff, X den um die Hydroxylgruppen verminderten Rest des Trimethylolpropans oder den um die Hydroxylgruppen verminderten Rest eines oxäthylierten Trimethylolpropans mit einer OH-Zahl von etwa 250 bis etwa 600, n etwa 2 und m + n etwa 3 bedeuten.

5. Verfahren zur Herstellung der Verbindungen der Formel (I) des Anspruchs 1, dadurch gekennzeichnet, daß die dem Rest X zugrundeliegenden, 3—6-wertigen Alkohole in Gegenwart oder Abwesenheit eines indifferenten Lösungsmittels auf Temperaturen zwischen 60 und 150°C, gegebenenfalls in Gegenwart eines Veresterungskatalysators mit der gegebenenfalls substituierten Arylglyoxylsäure und mit (Meth)Acrylsäure in beliebiger Reihenfolge oder gleichzeitig unter Wasserabspaltung bis zur praktisch vollständigen Veresterung der Säuren erhitzt werden.

6. Verwendung der Verbindungen der allgemeinen Formel (I) des Anspruchs 1 als Initiatoren für die Photopolymerisation olefinisch ungesättigter, photopolymerisierbarer, monomerer oder oligomerer Verbindungen oder deren Mischungen.

7. Photopolymerisierbare Bindemittel aus Mischungen von

A) 20—95 Gew.-% mindestens eines photopolymerisierbaren, mehr als eine olefinisch ungesättigte C—C-Doppelbindung enthaltenden Harzes aus der Gruppe der 1,2-Polyepoxide, der Polyester und Polyurethane.

B) 0—75 Gew.-% mindestens eines Acrylsäure- oder Methacrylsäureesters von ein- bis vierwertigem Alkohol oder Styrol oder deren Mischungen und

C) 5—80 Gew.-% mindestens eines Photoinitiators,

dadurch gekennzeichnet, daß die Mischung als Photoinitiator mindestens eine Verbindung der in Anspruch 1 angegebenen allgemeinen Formel (I) enthält.

8. Photopolymerisierbare Bindemittel gemäß Anspruch 7, dadurch gekennzeichnet, daß die Komponente A) einen ungesättigten Polyester mit vorwiegend —OOC—CH=CH—COO— Gruppen als photopolymerisierbare Gruppen, 1,2-Polyepoxide, deren 1,2-Epoxidgruppen mit 0,6 bis 1 Mol (Meth)Acrylsäure pro Mol Epoxidgruppe umgesetzt wurden, oder OH-Gruppen enthaltende Polyurethane, deren OH-Gruppen mit 0,6 — 1 Mol (Meth)Acrylsäure pro Mol OH-Gruppe verestert wurden, darstellt.

**Revendications**

1. Composés répondant à la formule générale I

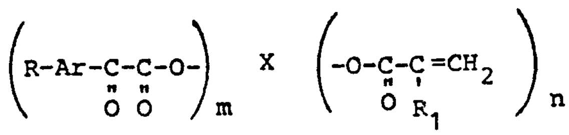 (I)

dans laquelle

Ar représente un reste phényle ou naphtyle,

R représente l'hydrogène, un groupe alkyle en $C_1$—$C_4$, alcoxy en $C_1$—$C_4$, un halogène, un groupe dialkylamino contenant de l à 4 atomes de carbone dans chacune des parties alkyle, un groupe carboxy, alcoxycarbonyle contenant de l à 4 atomes de carbone dans la partie alcoxy,

X est le reste de valence 3 à 6 d'un alcool saturé aliphatique de valence 3 à 6 après élimination de 3 à 6 groupes hydroxy, ou d'un tel alcool dont les chaînes aliphatiques sont interrompues ou reliées au moins une fois par l'un au moins des groupes

—O—, —S—, 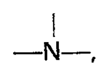, 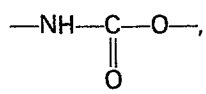, 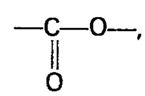, 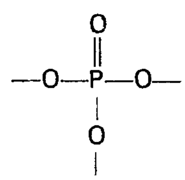

ces alcools présentant des indices de OH de 100 à 1850,

$R_1$ représente l'hydrogène ou un groupe méthyle

n est un nombre allant d'environ 2 à 5 et

n + m est un nombre allant d'environ 3 à 6.

2. Composés de formule I selon la revendication 1 dans laquelle Ar représente un groupe phényle, R représente l'hydrogène, X représente le reste de valence 3 à 6 d'un alcool saturé aliphatique de valence 3 à 6 après élimination de 3 à 6 groupes hydroxy ou d'un tel alcool dont les chaînes aliphatiques sont interrompues ou reliées au moins une fois par l'un au moins des groupes

—O—, 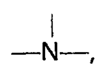, 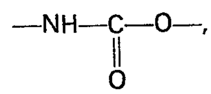, 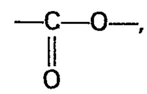,

ces alcools présentant des indices de OH de 100 à 1850, n est und nombre allant d'environ 2 à 5 et n + m un nombre allant d'environ 3 à 6.

3. Composés selon la revendication 2, caractérisés en ce que les chaînes aliphatiques de l'alcool sont interrompues au moins une fois par le groupe —O—.

4. Composés de formule I selon la revendication 1 dans laquelle Ar représente le groupe phényle, R représente l'hydrogène, X représente le reste du trimethylolpropane après élimination des groupes hydroxy ou le reste, après élimination des groupes hydroxy, d'un triméthylolpropane oxyéthylé présentant un indice de OH d'environ 250 à 600, n est égal à 2 environ et n + m à 3 environ.

5. Procédé de préparation des composés de formule I selon la revendication 1, caractérisé en ce que l'on chauffe les alcools de valence 3 à 6 dont dérive le reste X en présence ou en l'absence d'un solvant indifférent à des températures de 60 à 150°C, éventuellement en présence d'un catalyseur d'estérification, avec l'acide arylglyoxylique éventuellement substitué et avec l'acide acrylique ou méthacrylique dans un ordre quelconque ou simultanément, avec séparation d'eau jusqu'à estérification pratiquement complète des acides.

6. Utilisation des composés de formule générale I selon la revendication 1 en tant qu'inducteurs pour la photopolymérisation de composés monomères ou oligomères à insaturation oléfinique photopolymérisables ou de leurs mélanges.

7. Liants photopolymérisables consistant en mélanges de:

A) 20 à 95% en poids d'au moins une résine photopolymérisable contenant plus d'une double liaison C—C à insaturation oléfinique, prise dans le groupe des 1,2-polyépoxydes, des polyesters et des polyuréthannes;

B) 0 à 75% en poids d'au moins un ester acrylique ou méthacrylique d'alcool mono- à tétravalen ou de styrène ou de leurs mélanges et

C) 5 à 80% en poids d'au moins un photoinducteur, ces liants se caractérisant en ce que le mélange contient en tant que photoinducteur au moins un composé de formule générale I selon la revendication 1.

8. Liants photopolymérisables selon la revendication 7 caractérisés en ce que le composant A) consiste en un polyester insaturé contenant principalement, en tant que groupes photopolymérisables, des groupes —OOC—CH=CH—COO—, en 1,2-polyépoxydes dont les groupes 1,2-époxyde ont réagi avec 0,6 à 1 mole d'acide acrylique ou méthacrylique par mole de groupe époxyde, ou en polyuréthannes contenant des groupes OH et dont les groupes OH ont été estérifiés par 0,6 à 1 mole d'acide acrylique ou méthacrylique par mole de groupe OH.

**Claims**

1. Compounds of the general formula (I)

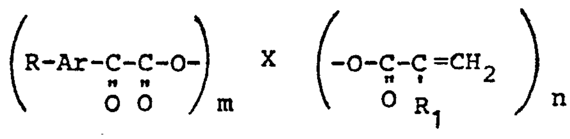

(I)

in which

Ar denotes phenyl or naphthyl,

R denotes hydrogen, alkyl with 1—4 carbon atoms, alkoxy with 1—4 carbon atoms, halogen, dialkylamino with 1—4 carbon atoms in every alkyl group, carboxy or alkoxycarbonyl with 1—4 carbon atoms in the alkoxy group,

X denotes the 3- to 6-valent radical of a 3- to 6-valent aliphatic saturated alcohol which has been diminished by 3 to 6 hydroxyl groups or of an afore-mentioned alcohol, whose aliphatic chains are interrupted or linked at least once by at least one of the groups

—O—, —S—, 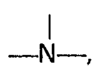, 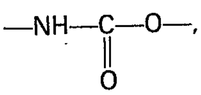, 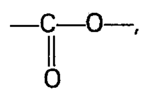, or 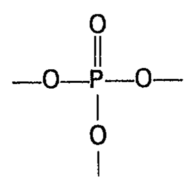

—the afore-mentioned alcohols have OH numbers from 100 to 1850—,

$R_1$ denotes hydrogen or methyl,

n denotes a number from about 2 to about 5 and

n + m denotes a number from about 3 to about 6.

2. Compounds according to formula (I) of claim 1; in which Ar denotes phenyl, R denotes hydrogen, X denotes the 3- to 6-valent radical of an aliphatic, saturated alcohol which has been diminished by 3 to 6 hydroxyl groups or of an aforementioned alcohol whose aliphatic chains are interrupted or linked at least once by at least one of the groups

—O—, 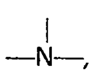, 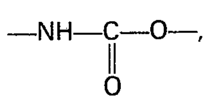, or 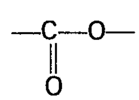

—the afore-mentioned alcohols have OH numbers from 100 to 1850—, n denotes a number from about 2 to about 5 and n + m denotes a number from about 3 to 6.

3. Compounds according to claim 2, in which the aliphatic chains of the alcohol are interrupted at least once by the group —O—.

4. Compounds according to formula (I) of claim 1, in which Ar denotes phenyl, R denotes hydrogen, X denotes the radical of trimethylol propane diminished by the hydroxyl groups, or the radical of an ethoxylated trimethylol propane diminished by the hydroxyl groups and having an OH number of about 250 to about 600, n denotes about 2 and m + n denotes about 3.

5. Process for the preparation of the compounds of formula (I) of claim 1, characterised in that the 3- to 6-valent alcohols forming the basis of the radical X are heated in the presence or in the absence of an indifferent solvent to temperatures between 60° and 150°C, optionally in the presence of an esterification catalyst, with optionally substituted arylglyoxylic acid and with (meth)acrylic acid either in any desired sequence or simultaneously, with elimination of water, until the acids are practically completely esterified.

6. Use of the compounds of the general formula (I) of claim 1 as initiators for the photopolymerisation of olefinically unsaturated, photopolymerizable monomeric or oligomeric compounds or mixtures thereof.

7. Photopolymerizable binders consisting of mixtures of

A) 20—95% by weight of at least one photopolymerizable resin containing more than one olefinically unsaturated C—C double bond, from the group consisting of 1,2-polyepoxides, polyesters and polyurethanes,

B) 0—75% by weight of at least one acrylic acid or methacrylic acid ester of a mono- to tetrahydric alcohol or styrene or mixtures thereof, and

C) 5—80% by weight of at least one photoinitiator, characterised in that the mixture contains as photoinitiator at least one compound of the general formula (I) mentioned in claim 1.

8. Photopolymerizable binder according to claim 7, characterized in that the component A) represents an unsaturated polyester containing mainly —OOC—CH=CH—COO— groups as photopolymerizable groups, 1,2-polyepoxides, whose 1,2-epoxide groups have been reacted with 0.6 to 1 mol of (meth)acrylic acid per mol of epoxide group, or polyurethanes containing OH groups, whose OH groups have been esterified with 0.6 to 1 mol of (meth)acrylic acid per mole of OH group.